# EUROPÄISCHE PATENTSCHRIFT

(11) **EP 3 812 161 B1**
(45) Veröffentlichungstag und Bekanntmachung des Hinweises auf die Patenterteilung: **27.09.2023**
(21) Anmeldenummer: 20203543.2
(22) Anmeldetag: 23.10.2020
(51) Int. Cl.: B41M 5/382, C23C 14/04, C23C 14/28

(54) **VERFAHREN UND VORRICHTUNG ZUM BESCHICHTEN EINES SUBSTRATS, ZUSCHNITT UND VERPACKUNG**
METHOD AND DEVICE FOR COATING A SUBSTRATE, BLANK AND PACKAGE
PROCÉDÉ ET DISPOSITIF DE REVÊTEMENT D'UN SUBSTRAT, DÉCOUPE ET EMBALLAGE

(30) Priorität: 25.10.2019 DE 102019128820
(43) Veröffentlichungstag der Anmeldung: 28.04.2021
(73) Patentinhaber: Mayr-Melnhof Karton AG, 1041 Wien (AT)
(72) Erfinder: THEIS, Uwe, 54317 Riveris (DE); VORENKAMP, Harman, 71549 Auenwald (DE)
(74) Vertreter: Hofstetter, Schurack & Partner

(56) Entgegenhaltungen:
- WO-A1-2010/069900
- WO-A1-2019/154826
- JP-A- 2018 089 974
- US-A1- 2003 178 395
- US-A1- 2019 088 804
- PERE SERRA ET AL: "Laser-Induced Forward Transfer: Fundamentals and Applications", ADVANCED MATERIALS TECHNOLOGIES, Bd. 4, Nr. 1, 8. August 2018 (2018-08-08), Seite 1800099, XP055597607, DE ISSN: 2365-709X, DOI: 10.1002/admt.201800099

## Beschreibung

Die Erfindung betrifft ein Verfahren und eine Vorrichtung zum Beschichten eines Substrats. Die Erfindung betrifft weiterhin einen Zuschnitt und eine Verpackung aus einem derartig beschichteten Substrat.

Aus dem Stand der Technik sind verschiedene Beschichtungsverfahren bekannt, um beispielsweise Verpackungsmaterialien aus Papier oder Karton oder andere Substrate zu beschichten. Im Bereich der Verpackungsindustrie wird in den meisten Fällen Siebdruck, Flexodruck, Tiefdruck oder Offsetdruck verwendet, um Farben, Lacke und dergleichen auf Substrate aufzubringen. Dies bringt jedoch gewisse Einschränkungen mit sich, da einerseits die Bildauflösung begrenzt ist und da andererseits die Schichtdicke durch die verwendeten Geräte, beispielsweise Siebstärke, Rasterwalze, Druckplatte oder Größe und Tiefe von Tiefdruckzylindern limitiert wird. Weiterhin ist die Anschaffung, Handhabung, Reinigung und Lagerung von Sieben, Rasterwalzen, Druckplatten, Tiefdruckzylinder und dergleichen aufwändig und kostenintensiv. Auch die Herstellung dieser Druckformen ist mit hohe Kosten und Lieferzeiten verbunden. Dies führt zu vergleichsweise hohen Kosten, was den Druck häufig unwirtschaftlich macht.

Die Publikation PERE SERRA ET AL, "Laser-Induced Forward Transfer: Fundamentals and Applications", ADVANCED MATERIALS TECHNOLOGIES, DE, (20180808), vol. 4, no. 1, gibt einen Überblick über verschiedene Varianten des sogenannten laserinduzierten Vorwärtsübertragungsverfahrens (Laser-induced Forward Transfer), bei welchem es sich um eine digitale Drucktechnik handelt, welche Laserpulse zum Übertragen von Material als Voxel auf ein Substrat nutzt.

Aus der WO 2019/154826 A1 geht ebenfalls ein Verfahren zur Übertragung einer Druckfarbe von einem Donor auf ein Substrat durch ein laserinduziertes Vorwärtsübertragungsverfahren hervor, wobei die Druckfarbe Metalloxid-haltige Teilchen enthält.

Die US 2019/088804 A1 offenbart ein Verfahren zur Metallisierung, umfassend die Bereitstellung eines transparenten Donorsubstrats, auf dem ein Donorfilm mit einem Metall mit einer Dicke von weniger als 2 µm abgeschieden ist. Das Donor-Substrat wird in der Nähe eines Akzeptor-Substrats positioniert, das ein Halbleitermaterial enthält, wobei der Donor-Film dem Akzeptor-Substrat zugewandt ist und zwischen dem Donor-Film und dem Akzeptor-Substrat ein Abstand von mindestens 0,1 mm besteht. Eine Folge von Laserimpulsen mit einer Impulsdauer von weniger als 2 ns wird so auf das Donorsubstrat gerichtet, dass Tröpfchen des Metalls aus der Donorschicht herausgeschleudert werden und auf dem Akzeptorsubstrat landen, wodurch eine Leiterbahn in ohmschem Kontakt mit dem Halbleitermaterial entsteht.

Die JP 2018-089974 A offenbart ein Druckverfahren umfassend das Drucken durch Bestrahlen einer mehrschichtigen laminierten Folie für den Laserdruck, die eine Grundmaterialschicht, eine Dichtungsschicht und eine dazwischen angeordnete Verdampfungsschicht aufweist, mit einem Laserstrahl mit einer Wellenlänge von 532 nm. Die Verdampfungsschicht ist eine Schicht, die ein Metall und/oder ein Metalloxid enthält und durch Bestrahlung mit dem Laserstrahl mit einer Wellenlänge von 532 nm verdampft wird.

Die WO 2010/069900 A1 offenbart ein Verfahren zum Bedrucken eines Substrates in einer Druckmaschine, bei dem Farbe von einem flexiblen Träger auf das Substrat entsprechend einem vorgegebenen Muster übertragen wird, indem Energie von einer Vorrichtung zum Einbringen von Energie durch den flexiblen Träger in die Farbe eingebracht wird, ein Teil der Farbe im Einwirkbereich der Energie verdampft und dadurch ein Farbtropfen auf das zu bedruckende Substrat geschleudert wird.

Die US 2003/178395 A1 offenbart eine Vorrichtung zur Herstellung von Miniaturstrukturen, die ein Substrat, einen steuerbaren Energiestrahl, eine auf einem Materialträgerelement getragene Abscheidungsschicht und eine Steuereinheit umfasst, die die Vorrichtung entweder in der Betriebsart "Materialabtrag" oder "Materialtransfer" betreibt. In der Betriebsart "Materialtransfer" verschiebt die Steuereinheit die Abscheidungsschicht so, dass sie einen Energiestrahl abfängt, so dass das in der Abscheidungsschicht enthaltene Material übertragen und auf der Oberfläche des Substrats in einer strukturierten Weise abgeschieden wird.

Aufgabe der vorliegenden Erfindung ist es, eine flexiblere Möglichkeit zum Beschichten von Substraten zu schaffen. Eine weitere Aufgabe der Erfindung ist es, einen Zuschnitt und eine Verpackung bereitzustellen, die flexibler beschichtet werden können.

Die Aufgaben werden erfindungsgemäß durch ein Verfahren mit den Merkmalen des Patentanspruchs 1, durch einen Zuschnitt gemäß Patentanspruch 12 sowie durch eine Verpackung gemäß Patentanspruch 13 gelöst. Vorteilhafte Ausgestaltungen mit zweckmäßigen Weiterbildungen der Erfindung sind in den jeweiligen Unteransprüchen angegeben, wobei vorteilhafte Ausgestaltungen jedes Erfindungsaspekts als vorteilhafte Ausgestaltungen der jeweils anderen Erfindungsaspekte anzusehen sind.

Ein erster Aspekt der Erfindung betrifft ein Verfahren zum Beschichten eines Substrats. Erfindungsgemäß wird eine flexiblere Beschichtbarkeit dadurch ermöglicht, dass zumindest die Schritte Bereitstellen eines Donors, welcher ein transparentes Donorsubstrat mit einer ersten Seite und einer dieser gegenüberliegenden zweite Seite aufweist, wobei an der zweiten Seite zumindest eine Donorschicht angeordnet ist, Anordnen des Donors in einem vorbestimmten Abstand zum Substrat, wobei die Donorschicht dem Substrat zugewendet wird, und Leiten wenigstens eines Energiestrahls durch die erste Seite des Donorsubstrats auf die Donorschicht gemäß einer Bestrahlungsstrategie, so dass ein Teil der Donorschicht vom Donor abgetrennt und auf das Substrat transferiert wird, durchgeführt werden. Erfindungsgemäß wird das Substrat ausgewählt aus einer Gruppe, die aus Papier, Karton und Pappe oder einer beliebigen Kombination hieraus besteht. Weiterhin wird ein Donor verwendet, welcher auf der dem Donorsubstrat abgewandten Seite der Donorschicht wenigstens eine zusätzliche Beschichtung aus einem Haftkleber aufweist. Hierdurch können unterschiedliche Substrate auf einfache, flexible und kostengünstige Weise druckformfrei und berührungslos mit unterschiedlichen Donormaterialien beschichtet werden. Zusätzlich können auf diese Weise besonders einfach unterscheidlich dicke Beschichtungen erzeugt werden. Die Dicke einer entsprechend hergestellten Beschichtung kann beispielsweise zwischen 0,2 µm und 30 µm, insbesondere zwischen 2 µm und 20 µm, vorzugsweise zwischen 2,1 µm und 15 µm, betragen und gegebenenfalls ein- oder mehrmals innerhalb eines Druckvorgangs variiert werden, um lokal unterschiedlich dicke Beschichtungen herzustellen. Das jeweilige Beschichtungsmuster kann durch einfache Veränderung oder Anpassung der Bestrahlungsstrategie, beispielsweise durch die Wahl von gewünschten digitalen Druckdaten, geändert bzw. angepasst werden, was eine entsprechend flexible Steuerung bzw. Regelung des Energiestrahls ermöglicht. Die aufwändige und zeit- und kostenintensive Handhabung von Druckformen und sonstigen Druckwerkzeugen entfällt vorteilhaft. Das bereitgestellte Substrat kann vor dem Transfer des Donormaterials unbedruckt bzw. unbeschichtet sein oder bereits ein- oder mehrseitig bedruckt bzw. beschichtet vorliegen. Unter Papier wird vorliegend nach DIN 6735 ein flächiger, im Wesentlichen aus Fasern meist pflanzlicher Herkunft bestehender Werkstoff verstanden, der durch Entwässerung einer Faserstoffaufschwemmung auf einem Sieb gebildet wird. Dabei entsteht ein Faserfilz, der anschließend verdichtet und getrocknet wird und eine flächenbezogene Masse ≤ 225 g/m² besitzt. Unter Karton wird vorliegend ein entsprechendes Flächengebilde mit flächenbezogenen Massen im Bereich von 225 bis 600 g/m² verstanden, während Pappe dementsprechend eine flächenbezogene Masse über 600 g/m² aufweist. Gemäß DIN 6735 wird dabei unter Pappe sowohl Vollpappe als auch Wellpappe verstanden. Durch den Haftkleber kann die Haftung des transferierten Donormaterials am Substrat verbessert bzw. zur Beschichtung von Substraten genutzt werden, die sich normalerweise nicht oder nur schlecht mit dem betreffenden Donormaterial beschichten lassen würden. Generell sind "ein/eine" im Rahmen dieser Offenbarung als unbestimmte Artikel zu lesen, also ohne ausdrücklich gegenteilige Angabe immer auch als "mindestens ein/mindestens eine". Umgekehrt können "ein/eine" auch als "nur ein/nur eine" verstanden werden.

In einer weiteren vorteilhaften Ausgestaltung ist es vorgesehen, dass als Donorsubstrat eine transparente Kunststofffolie verwendet wird und/oder dass das Donorsubstrat ausgewählt wird aus einer Gruppe, die Polyester, Polyamid und Polypropylen umfasst. Hierdurch können besonders reißfeste, kostengünstige und einfach mit der Donorschicht zu versehende Donorsubstrate in unterschiedlichen Dimensionen bereitgestellt werden.

Weitere Vorteile ergeben sich, indem ein Donorsubstrat mit einer Dicke zwischen 3 µm und 35 µm, das heißt beispielsweise mit einer Dicke von 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, 21 µm, 22 µm, 23 µm, 24 µm, 25 µm, 26 µm, 27 µm, 28 µm, 29 µm, 30 µm, 31 µm, 32 µm, 33 µm, 34 µm oder 35 µm verwendet wird, wobei sämtliche Zwischenwerte und -bereiche als mitoffenbart anzusehen sind. Alternativ oder zusätzlich ist es vorgesehen, dass eine Donorschicht mit einer Dicke zwischen 0,1 µm und 40 µm, das heißt beispielsweise mit einer Dicke von 0,1 µm, 0,2 µm, 0,3 µm, 0,4 µm, 0,5 µm, 0,6 µm, 0,7 µm, 0,8 µm, 0,9 µm, 1,0 µm, 2 µm, 3 µm, 4 µm, 5 µm, 6 µm, 7 µm, 8 µm, 9 µm, 10 µm, 11 µm, 12 µm, 13 µm, 14 µm, 15 µm, 16 µm, 17 µm, 18 µm, 19 µm, 20 µm, 21 µm, 22 µm, 23 µm, 24 µm, 25 µm, 26 µm, 27 µm, 28 µm, 29 µm, 30 µm, 31 µm, 32 µm, 33 µm, 34 µm, 35 µm, 36 µm, 37 µm, 38 µm, 39 µm oder 40 µm verwendet wird, wobei sämtliche Zwischenwerte und -bereiche als mitoffenbart anzusehen sind. Hierdurch können die mechanischen und optischen Eigenschaften des Donorsubstrats sowie der Materialtransfer von der Donorschicht zum Substrat optimal an die jeweiligen Gegebenheiten angepasst werden.

In einer weiteren vorteilhaften Ausgestaltung der Erfindung ist vorgesehen, dass eine elektrisch leitfähige Donorschicht verwendet wird, insbesondere aus einem Metall und/oder einer Metalllegierung und/oder einem Halbleiter. Beispielsweise kann die Donorschicht Aluminium, Silber, Kupfer, Gold, Titan bzw. eine Mischung bzw. ein Schichtsystem hieraus umfassen. Ebenso können eine oder mehrere Legierungen der genannten oder anderer Metalle vorgesehen sein. Weiterhin können Halbleiter beispielsweise auf Silizium-, Germanium- oder Kohlenstoffbasis bzw. Halbleiterverbindungen wie Galliumarsenid, Indiumantimonid, Cadmiumtellurid etc. verwendet werden. Hierdurch können metallisch glänzende Schichten und/oder elektrische Schaltungen oder Verbindungen auf dem Substrat realisiert werden. Alternativ oder zusätzlich ist es vorgesehen, dass ein Donor verwendet wird, welcher mindestens zwei Donorschichten umfasst. Durch geeignete Auswahl der zwei oder mehr Donormaterialien können entsprechend gut an den jeweiligen Einsatzzweck angepasste Beschichtungen erzeugt werden. Die Donorschichten können dabei grundsätzlich gleich oder unterschiedlich ausgebildet sein, beispielsweise aus unterschiedlichen Donormaterialien bestehen und/oder unterschiedliche Dicken aufweisen.

Weitere Vorteile ergeben sich dadurch, dass ein Donor verwendet wird, welcher auf der Donorschicht wenigstens eine zusätzliche Beschichtung aus einem Oxid aufweist. Mit anderen Worten ist auf der dem Donorsubstrat abgewandten Seite der Donorschicht eine weitere Beschichtung angeordnet, durch welche eine zusätzliche Anpassbarkeit an die jeweilige Beschichtungsaufgabe ermöglicht ist. Beispielsweise können ein oder mehrere Oxide wie beispielsweise SiOz und/oder ein Oxid eines Metalls der Donorschicht vorgesehen sein, wodurch die chemischen, mechanischen und optischen Eigenschaften der Beschichtung variiert werden können.

Insbesondere bei der Verwendung von hochschmelzenden Donormaterialien hat es sich als vorteilhaft gezeigt, wenn zumindest die Donorschicht auf eine vorbestimmte Temperatur, insbesondere auf eine Temperatur zwischen 30 °C und 250 °C, das heißt auf beispielsweise 30°C, 31°C, 32°C, 33°C, 34°C, 35°C, 36°C, 37°C, 38°C, 39°C, 40°C, 41°C, 42°C, 43°C, 44°C, 45°C, 46°C, 47°C, 48°C, 49°C, 50°C, 51°C, 52°C, 53°C, 54°C, 55°C, 56°C, 57°C, 58°C, 59°C, 60°C, 61°C, 62°C, 63°C, 64°C, 65°C, 66°C, 67°C, 68°C, 69°C, 70°C, 71°C, 72°C, 73°C, 74°C, 75°C, 76°C, 77°C, 78°C, 79°C, 80°C, 81°C, 82°C, 83°C, 84°C, 85°C, 86°C, 87°C, 88°C, 89°C, 90°C, 91°C, 92°C, 93°C, 94°C, 95°C, 96°C, 97°C, 98°C, 99°C, 100°C, 101°C, 102°C, 103°C, 104°C, 105°C, 106°C, 107°C, 108°C, 109°C, 110°C, 111°C, 112°C, 113°C, 114°C, 115°C, 116°C, 117°C, 118°C, 119°C, 120°C, 121°C, 122°C, 123°C, 124°C, 125°C, 126°C, 127°C, 128°C, 129°C, 130°C, 131°C, 132°C, 133°C, 134°C, 135°C, 136°C, 137°C, 138°C, 139°C, 140°C, 141°C, 142°C, 143°C, 144°C, 145°C, 146°C, 147°C, 148°C, 149°C, 150°C, 151°C, 152°C, 153°C, 154°C, 155°C, 156°C, 157°C, 158°C, 159°C, 160°C, 161°C, 162°C, 163°C, 164°C, 165°C, 166°C, 167°C, 168°C, 169°C, 170°C, 171°C, 172°C, 173°C, 174°C, 175°C, 176°C, 177°C, 178°C, 179°C, 180°C, 181°C, 182°C, 183°C, 184°C, 185°C, 186°C, 187°C, 188°C, 189°C, 190°C, 191°C, 192°C, 193°C, 194°C, 195°C, 196°C, 197°C, 198°C, 199°C, 200°C, 201°C, 202°C, 203°C, 204°C, 205°C, 206°C, 207°C, 208°C, 209°C, 210°C, 211°C, 212°C, 213°C, 214°C, 215°C, 216°C, 217°C, 218°C, 219°C, 220°C, 221°C, 222°C, 223°C, 224°C, 225°C, 226°C, 227°C, 228°C, 229°C, 230°C, 231°C, 232°C, 233°C, 234°C, 235°C, 236°C, 237°C, 238°C, 239°C, 240°C, 241°C, 242°C, 243°C, 244°C, 245°C, 246°C, 247°C, 248°C, 249°C oder 250°C temperiert wird. Grundsätzlich kann gegebenenfalls auch der gesamte Donor zumindest im Transferbereich erwärmt werden. Die Art der Erwärmung kann bedarfsweise gewählt werden, beispielsweise aus Strahlungsheizungen, Widerstandsheizungen oder induktiven Heizungen. Hierdurch kann mit einer relativ geringen Energiestrahlleistung gearbeitet werden, da nur ein vergleichsweise geringerer Energieeintrag in die Donorschicht erforderlich ist, um den Transfer des Donormaterials zu bewirken. Vorzugsweise wird die Temperatur in Abhängigkeit der Eigenschaften des Donorsubstrats gewählt, um eine Schwächung oder Beschädigung zu vermeiden.

Indem der Donor in einem Abstand zwischen 0 mm und 20 mm, also beispielsweise von 0 mm, 1 mm, 2 mm, 3 mm, 4 mm, 5 mm, 6 mm, 7 mm, 8 mm, 9 mm, 10 mm, 11 mm, 12 mm, 13 mm, 14 mm, 15 mm, 16 mm, 17 mm, 18 mm, 19 mm oder 20 mm zum Substrat angeordnet wird, können die Beschichtungseigenschaften des Substrats und des Donormaterials optimal berücksichtigt werden.

Weitere Vorteile ergeben sich dadurch, dass ein Sauerstoffgehalt einer Umgebungsatmosphäre auf einen vorbestimmten Wert eingestellt wird und/oder dass zumindest ein Bereich, in dem ein Teil der Donorschicht vom Donor abgetrennt und auf das Substrat transferiert wird, mit einem Schutzgas beaufschlagt und/oder zumindest teilweise evakuiert wird. Mit anderen Worten ist es vorgesehen, dass zumindest in dem Bereich, in welchem der Transfer stattfindet, der Sauerstoffgehalt der Umgebungsatmosphäre kontrolliert wird, wodurch insbesondere eine Oxidation des Donormaterials wahlweise entweder verhindert oder befördert werden kann. Die Kontrolle des Sauerstoffgehalts kann auf mehrere Weisen stattfinden, beispielsweise durch Entfernen oder Beifügen von Sauerstoff zur normalen Atmosphäre, durch Beaufschlagen des betreffenden Bereichs mit Schutzgas oder durch teilweise oder vollständige Evakuierung.

Weitere Vorteile ergeben sich, indem als Energiestrahl ein Laserstrahl und/oder ein Elektronenstrahl verwendet wird. Hierdurch kann das Beschichtungsverfahren optimal an die jeweiligen Materialpaarungen und die gewünschten Eigenschaften der herzustellenden Beschichtung angepasst werden. Alternativ oder zusätzlich ist es vorgesehen, dass der Energiestrahl gepulst wird, insbesondere mit einer Pulsdauer zwischen 1 fs und 1 ms, also beispielsweise mit einer Pulsdauer von 10⁻¹⁵, 10⁻¹⁴, 10⁻¹³, 10⁻¹², 10⁻¹¹, 10⁻¹⁰, 10⁻⁹, 10⁻⁸, 10⁻⁷ oder 10⁻⁶ Sekunden, wobei entsprechende Zwischenwerte und -bereiche als mitoffenbart anzusehen sind. Hierdurch können der Energieeintrag in das Donormaterial und damit die Schichtdicke besonders präzise eingestellt werden. Alternativ oder zusätzlich ist es vorgesehen, dass eine Leistung des Energiestrahls derart eingestellt wird, dass der abzutrennende Teil der Donorschicht zumindest teilweise verdampft und/oder schmilzt. Dies stellt einen zuverlässigen Transfer sowie eine gute Abdeckung und Anhaftung auf dem Substrat sicher.

Weitere Vorteile ergeben sich, indem ein bahnförmiges Substrat und/oder ein bahnförmiger Donor verwendet wird. Dies erlaubt eine besonders flexible Beschichtung. Generell können das Substrat und der Donor während des Beschichtens relativ zueinander feststehen oder gemeinsam oder relativ zueinander bewegt werden. Beispielsweise kann der bahnförmige Donor in der Art eines Farbbandes relativ zum Substrat bzw. am Substrat entlang bewegt werden, um eine kontinuierliche und gleichmäßige Beschichtung sicherzustellen und um zu verhindern, dass bereits transferierte Donorbereiche, die frei von Donormaterial sind, erneut mit dem Energiestrahl beaufschlagt werden, was zu Lücken in der Beschichtung führen könnte.

In weiterer Ausgestaltung hat es sich als vorteilhaft gezeigt, wenn das Substrat nach dem Transfer des Donors zumindest bereichsweise bedruckt wird. Hierdurch kann die hergestellte Transferbeschichtung geschützt und/oder mit weiteren optischen und/oder funktionellen Schichten versehen werden.

Ein nicht-erfindungsgemäßer Aspekt der Offenbarung betrifft eine Vorrichtung zum Durchführen eines Verfahrens gemäß dem ersten Erfindungsaspekt. Die Vorrichtung umfasst eine Halteeinrichtung für das Substrat, eine Halteeinrichtung für den Donor, eine Einstelleinrichtung, mittels welcher das Substrat und der Donor im vorbestimmten Abstand zueinander anordenbar sind, sowie eine Einrichtung zum Erzeugen des Energiestrahls. Dies erlaubt einer besonders flexible Beschichtung unterschiedlicher Substrate mit unterschiedlichen Donormaterialien. Die Einrichtung zum Erzeugen des Energiestrahls kann generell feststehend oder relativ zum Substrat beweglich sein, um den Fokuspunkt des Energiestrahls besonders schnell und präzise auch über großflächige Substrate bewegen zu können. Die Einrichtung zum Erzeugen des Energiestrahls kann generell neben einer Strahlenquelle auch ein Modulations-, Strahlführungs- und/oder - formungssystem enthalten.

Ein zweiter Aspekt der Erfindung betrifft einen Zuschnitt für eine Verpackung, umfassend ein Substrat, welches gemäß einem Verfahren nach dem ersten Erfindungsaspekt hergestellt ist. Die sich hieraus ergebenden Merkmale und deren Vorteile sind den Beschreibungen des ersten Erfindungsaspekts zu entnehmen.

Ein dritter Aspekt der Erfindung betrifft eine Verpackung, insbesondere für Tabakwaren und/oder Liquids, welche aus einem Zuschnitt gemäß dem zweiten Erfindungsaspekt hergestellt ist. Die sich hieraus ergebenden Merkmale und deren Vorteile sind den Beschreibungen des ersten Erfindungsaspekts zu entnehmen.

Weitere Merkmale der Erfindung ergeben sich aus den Ansprüchen, den Figuren und der Figurenbeschreibung. Die vorstehend in der Beschreibung genannten Merkmale und Merkmalskombinationen, sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale eines ursprünglich formulierten unabhängigen Anspruchs aufweisen. Es sind darüber hinaus Ausführungen und Merkmalskombinationen, insbesondere durch die oben dargelegten Ausführungen, als offenbart anzusehen, die über die in den Rückbezügen der Ansprüche dargelegten Merkmalskombinationen hinausgehen oder von diesen abweichen. Dabei zeigt:
- Fig. 1: eine Prinzipdarstellung einer nicht-erfindungsgemäßen Vorrichtung zum Beschichten eins Substrats;
- Fig. 2: eine Prinzipdarstellung der Vorrichtung, welche mittels eines Energiestrahls ein Donormaterial auf ein Substrat transferiert;
- Fig. 3: eine Prinzipdarstellung des beschichteten Substrats und eines Donors; und
- Fig. 4: eine Prinzipdarstellung eines Substrats, das erfindungsgemäß mit einem alternativen Donormaterial beschichtet ist.

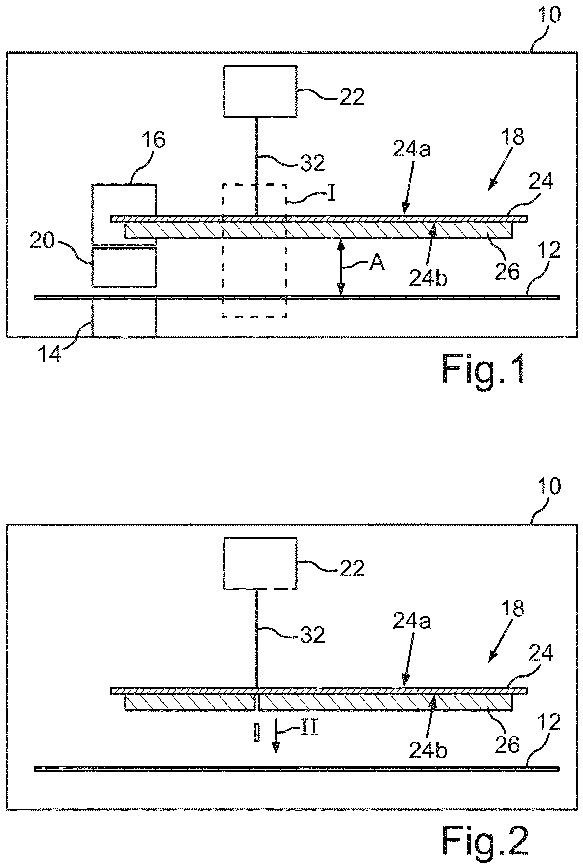

**Fig. 1** zeigt eine nicht-erfindungsgemäße Vorrichtung 10 zum Beschichten eines Substrats 12. Die Vorrichtung 10 umfasst eine Halteeinrichtung 14 für das Substrat 12, eine Halteeinrichtung 16 für den Donor 18, eine Einstelleinrichtung 20, mittels welcher das Substrat 12 und der Donor 18 in einem vorbestimmten Abstand A, beispielsweise zwischen 0 mm und 10 mm, zueinander anordenbar sind, sowie eine Einrichtung 22 zum Erzeugen des Energiestrahls 32, bei welchem es sich vorliegend exemplarisch um einen Laserstrahl handelt.

Der Donor 18 umfasst ein transparentes Donorsubstrat 24, welches exemplarisch aus Polyester oder Polyamid besteht, mit einer ersten Seite 24a und einer dieser gegenüberliegenden zweite Seite 24b, wobei an der zweiten Seite 24b zumindest eine Donorschicht 26 angeordnet ist. Die Donorschicht 26 besteht im gezeigten Beispiel aus Aluminium und besitzt eine Dicke zwischen 3 µm und 30 µm. Die Donorschicht 26 kann beispielsweise durch einen Vakuumbeschichtungsprozess (PVD, CVD) oder durch ein Klebeverfahren auf dem Donorsubstrat 24 angeordnet werden. Die Donorschicht 26 kann generell auch mehrere Schichten aus den gleichen oder aus unterschiedlichen Donormaterialien umfassen. Im gezeigten Beispiel ist das Donorsubstrat 24 bahnförmig und wird kontinuierlich von einer Rolle (nicht gezeigt) abgewickelt und am Substrat 12 vorbeigeführt. Man erkennt, dass die Donorschicht 26 dabei dem Substrat 12 zugewandt ist.

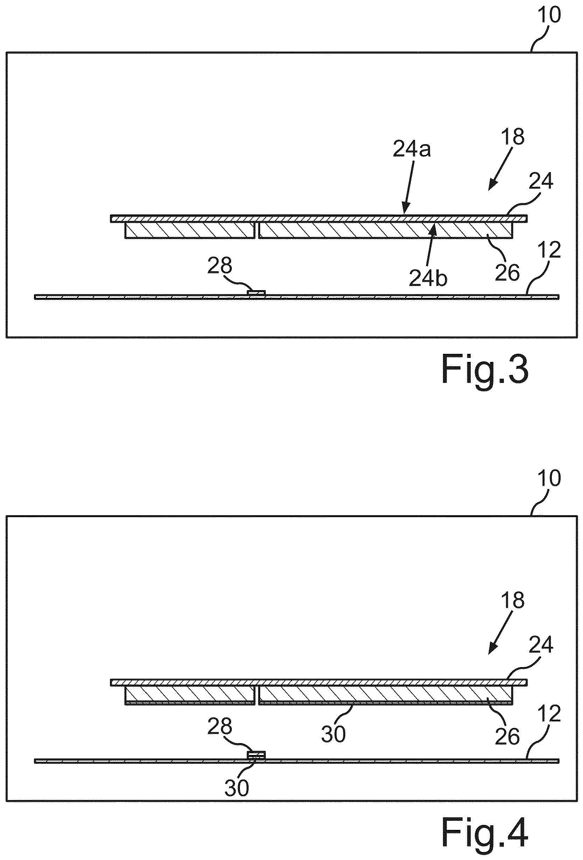

Zum Beschichten wird der Energiestrahl 32 durch die erste Seite 24a des für den Energiestrahl 32 transparenten Donorsubstrats 24 auf die Donorschicht 26 gemäß einer Bestrahlungsstrategie gelenkt, so dass ein Teil der Donorschicht 26 vom Donor 18 abgetrennt und gemäß Pfeil II auf das Substrat 12 transferiert wird. Dies ist in **Fig. 2** dargestellt, wobei die restlichen Elemente der Vorrichtung 10 aus Gründen der Übersichtlichkeit nicht abgebildet sind. Der Transfer beruht auf der partiellen Verdampfung des Donormaterials, das vorzugsweise in zumindest partiell geschmolzenem Zustand vom Donorsubstrat 24 abgelöst und auf das Substrat 12 beschleunigt wird, wo es sich gegebenenfalls umformt und zur Beschichtung 28 erstarrt. Dieser Zustand ist in **Fig. 3** gezeigt, wobei die in den vorherigen Figuren gezeigten Elemente der Vorrichtung 10 erneut aus Gründen der Übersichtlichkeit nicht dargestellt sind. Auf diese Weise kann eine glatte, geschlossene Beschichtung 28 erzeugt werden.

Zumindest der Bereich I, in welchem das Beschichten erfolgt, kann mit einem Schutzgas beaufschlagt werden, um eine Oxidierung des Donormaterials zu verhindern. Ebenso kann es vorgesehen sein, dass ein Teil oder der gesamte Innenraum der Vorrichtung 10 mit einer Schutzgasatmosphäre bzw. mit einer Atmosphäre mit kontrolliertem Sauerstoffgehalt gefüllt wird.

**Fig. 4** zeigt eine Prinzipdarstellung eines Substrats 12, das erfindungsgemäß mit einem alternativen Donormaterial beschichtet ist. Hierzu weist der Donor 18 neben dem transparenten Donorsubstrat 24 und der Donorschicht 26 eine zusätzliche Beschichtung 30 auf, welche einen Haftkleber und optional SiO₂ umfassen kann. Hierdurch können sowohl die Haftung als auch die optischen und mechanischen Eigenschaften der Beschichtung 28 eingestellt und an das Substrat 12 angepasst werden.

Bevorzugte Anwendungen umfassen das Aufbringen einer Metallschicht auf mit Farben und/oder Lacken zu überdruckende Substrate 12, wie sie für Zuschnitte und Verpackungsmaterialien benötigt werden. Die Dicke der Beschichtung 28 beträgt dabei vorzugsweise zwischen 0,2 µm und 30 µm. Ebenso kann die Beschichtung 28 als sauerstoff- und/oder wasserfeste Sperr- bzw. Barriereschicht, insbesondere für gedruckte Elektroniksubstrate 12, ausgebildet werden. Entsprechend können auch elektrisch leitfähige bzw. induktive Beschichtungen 28 speziell für gedruckte Elektroniksubstrate hergestellt werden.

Die in den Unterlagen angegebenen Parameterwerte zur Definition von Prozess- und Messbedingungen für die Charakterisierung von spezifischen Eigenschaften des Erfindungsgegenstands sind auch im Rahmen von Abweichungen - beispielsweise aufgrund von Messfehlern, Systemfehlern, Einwaagefehlern, DIN-Toleranzen und dergleichen - als vom Rahmen der Erfindung mitumfasst anzusehen.

## Patentansprüche

1. Verfahren zum Beschichten eines Substrats (12), umfassend die Schritte:
- Bereitstellen eines Donors (18), welcher ein transparentes Donorsubstrat (24) mit einer ersten Seite (24a) und einer dieser gegenüberliegenden zweite Seite (24b) aufweist, wobei an der zweiten Seite (24b) zumindest eine Donorschicht (26) angeordnet ist;
- Anordnen des Donors (18) in einem vorbestimmten Abstand (A) zum Substrat (12), wobei die Donorschicht (26) dem Substrat (12) zugewendet wird;
- Leiten wenigstens eines Energiestrahls (32) durch die erste Seite (24a) des Donorsubstrats (24) auf die Donorschicht (26) gemäß einer Bestrahlungsstrategie, so dass ein Teil der Donorschicht (26) vom Donor (18) abgetrennt und auf das Substrat (12) transferiert wird, wobei
- das Substrat (12) ausgewählt wird aus einer Gruppe, die aus Papier, Karton und Pappe oder einer beliebigen Kombination hieraus besteht, **dadurch gekennzeichnet, dass**
- ein Donor (18) verwendet wird, welcher auf der dem Donorsubstrat (24) abgewandten Seite der Donorschicht (26) wenigstens eine zusätzliche Beschichtung (30) aus einem Haftkleber aufweist.

2. Verfahren nach Anspruch 1,
**dadurch gekennzeichnet, dass**
als Donorsubstrat (24) eine transparente Kunststofffolie verwendet wird und/oder dass das Donorsubstrat (24) ausgewählt wird aus einer Gruppe, die Polyester, Polyamid und Polypropylen umfasst.

3. Verfahren nach einem der Ansprüche 1 oder 2,
**dadurch gekennzeichnet, dass**
ein Donorsubstrat (24) mit einer Dicke zwischen 3 µm und 35 µm und/oder eine Donorschicht (26) mit einer Dicke zwischen 0,1 µm und 40 µm, insbesondere zwischen 7 µm und 30 µm verwendet wird.

4. Verfahren nach einem der Ansprüche 1 bis 3,
**dadurch gekennzeichnet, dass**
eine elektrisch leitfähige Donorschicht (26) verwendet wird, insbesondere aus einem Metall und/oder einer Metalllegierung und/oder einem Halbleiter, und/oder dass ein Donor (18) verwendet wird, welcher mindestens zwei Donorschichten (26) umfasst.

5. Verfahren nach einem der Ansprüche 1 bis 4,
**dadurch gekennzeichnet, dass**
ein Donor (18) verwendet wird, welcher auf der Donorschicht (26) wenigstens eine zusätzliche Beschichtung (30) aus einem Oxid aufweist.

6. Verfahren nach einem der Ansprüche 1 bis 5,
**dadurch gekennzeichnet, dass**
zumindest die Donorschicht (26) auf eine vorbestimmte Temperatur, insbesondere auf eine Temperatur zwischen 30 °C und 250 °C, temperiert wird.

7. Verfahren nach einem der Ansprüche 1 bis 6,
**dadurch gekennzeichnet, dass**
der Donor (18) in einem Abstand (A) zwischen 0 mm und 20 mm zum Substrat (12) angeordnet wird.

8. Verfahren nach einem der Ansprüche 1 bis 7,
**dadurch gekennzeichnet, dass**
der Sauerstoffgehalt der Umgebungsatmosphäre in dem Bereich in welchem der Transfer stattfindet auf einen vorbestimmten Wert eingestellt wird und/oder dass zumindest ein Bereich, in dem ein Teil der Donorschicht (26) vom Donor (18) abgetrennt und auf das Substrat transferiert wird, mit einem Schutzgas beaufschlagt und/oder zumindest teilweise evakuiert wird.

9. Verfahren nach einem der Ansprüche 1 bis 8,
**dadurch gekennzeichnet, dass**
als Energiestrahl (32) ein Laserstrahl und/oder ein Elektronenstrahl verwendet wird und/oder dass der Energiestrahl (32) gepulst wird, insbesondere mit einer Pulsdauer zwischen 1 fs und 1 ms, und/oder dass eine Leistung des Energiestrahls (32) derart eingestellt wird, dass der abzutrennende Teil der Donorschicht (26) zumindest teilweise verdampft und/oder schmilzt.

10. Verfahren nach einem der Ansprüche 1 bis 9,
**dadurch gekennzeichnet, dass**
ein bahnförmiges Substrat (12) und/oder ein bahnförmiger Donor (18) verwendet wird.

11. Verfahren nach einem der Ansprüche 1 bis 10,
**dadurch gekennzeichnet, dass**
das Substrat (12) nach dem Transfer des Donors (18) zumindest bereichsweise bedruckt wird.

12. Zuschnitt für eine Verpackung, umfassend ein Substrat (12), welches gemäß einem Verfahren nach einem der Ansprüche 1 bis 11 hergestellt ist.

13. Verpackung, insbesondere für Tabakwaren und/oder Liquids, welche aus einem Zuschnitt gemäß Anspruch 12 hergestellt ist.

## Claims

1. A method for coating a substrate (12) comprising the steps:
- providing a donor (18), which comprises a transparent donor substrate (24) with a first side (24a) and a second side (24b) opposing it, wherein at least one donor layer (26) is arranged on the second side (24b);
- arranging the donor (18) at a predetermined distance (A) to the substrate (12), wherein the donor layer (26) is turned towards the substrate (12);
- passing at least one energy beam (32) through the first side (24a) of the donor substrate (24) onto the donor layer (26) according to an irradiation strategy such that a part of the donor layer (26) is separated from the donor (18) and transferred to the substrate (12),
wherein
- the substrate (12) is selected from a group consisting of paper, cardboard and paperboard or any combination from it, **characterized in that**
- a donor (18) is used, which comprises at least one additional coating (30) of an adhesive glue on the side of the donor layer (26) facing away from the donor substrate (24).

2. The method according to claim 1,
**characterized in that**
a transparent plastic foil is used as the donor substrate (24) and/or that the donor substrate (24) is selected from a group, which includes polyester, polyamide and polypropylene.

3. The method according to any one of claims 1 or 2,
**characterized in that**
a donor substrate (24) with a thickness between 3 µm and 35 µm and/or a donor layer (26) with a thickness between 0.1 µm and 40 µm, in particular between 7 µm and 30 µm, are used.

4. The method according to any one of claims 1 to 3,
**characterized in that**
an electrically conductive donor layer (26) is used, in particular of a metal and/or a metal alloy and/or a semiconductor, and/or that a donor (18) is used, which includes at least two donor layers (26).

5. The method according to any one of claims 1 to 4,
**characterized in that**
a donor (18) is used, which comprises at least one additional coating (30) of an oxide on the donor layer (26).

6. The method according to any one of claims 1 to 5,
**characterized in that**
at least the donor layer (26) is tempered to a predetermined temperature, in particular to a temperature between 30 °C and 250 °C.

7. The method according to any one of claims 1 to 6,
**characterized in that**
the donor (18) is arranged at a distance (A) between 0 mm and 20 mm to the substrate (12).

8. The method according to any one of claims 1 to 7,
**characterized in that**
the oxygen content of the ambient atmosphere in the area, in which the transfer occurs, is adjusted to a predetermined value and/or that at least an area, in which a part of the donor layer (26) is separated from the donor (18) and transferred to the substrate, is supplied with a protective gas and/or at least partially evacuated.

9. The method according to any one of claims 1 to 8,
**characterized in that**
a laser beam and/or an electron beam are used as the energy beam (32) and/or that the energy beam (32) is pulsed, in particular with a pulse duration between 1 fs and 1 ms, and/or that a power of the energy beam (32) is adjusted such that the part of the donor layer (26) to be separated at least partially evaporates and/or melts.

10. The method according to any one of claims 1 to 9,
**characterized in that**
a web-shaped substrate (12) and/or a web-shaped donor (18) are used.

11. The method according to any one of claims 1 to 10,
**characterized in that**
the substrate (12) is imprinted at least in certain areas after the transfer of the donor (18).

12. A blank for a packaging comprising a substrate (12), which is produced according to a method according to any one of claims 1 to 11.

13. A packaging, in particular for tobacco products and/or liquids, which is produced from a blank according to claim 12.

## Revendications

1. Procédé de revêtement d'un substrat (12), comprenant les étapes consistant à :
- fournir un donneur (18) comportant un substrat donneur transparent (24) ayant une première face (24a) et une seconde face (24b) opposée à celle-ci, au moins une couche donneuse (26) étant disposée sur la seconde face (24b) ;
- disposer le donneur (18) à une distance prédéfinie (A) du substrat (12), la couche donneuse (26) étant dirigée vers le substrat (12) ;
- guider au moins un faisceau d'énergie (32) à travers la première face (24a) du substrat donneur (24) vers la couche donneuse (26) selon une stratégie de rayonnement, de telle sorte qu'une partie de la couche donneuse (26) est séparée du donneur (18) et transférée sur le substrat (12),
- le substrat (12) étant choisi parmi un groupe constitué de papier, de carton et de papier cartonné ou de toute combinaison de ceux-ci, **caractérisé en ce que**
- un donneur (18) est utilisé, lequel donneur comporte au moins un revêtement supplémentaire (30) constitué d'un adhésif sur la face de la couche donneuse (26) opposée au substrat donneur (24).

2. Procédé selon la revendication 1,
**caractérisé en ce que**
un film de matière plastique transparent est utilisé en tant que substrat donneur (24) et/ou **en ce que** le substrat donneur (24) est choisi parmi un groupe incluant un polyester, un polyamide et un polypropylène.

3. Procédé selon l'une des revendications 1 ou 2,
**caractérisé en ce que**
un substrat donneur (24) ayant une épaisseur comprise entre 3 µm et 35 µm et/ou une couche donneuse (26) ayant une épaisseur comprise entre 0,1 µm et 40 µm, en particulier comprise entre 7 µm et 30 µm, est utilisé.

4. Procédé selon l'une des revendications 1 à 3,
**caractérisé en ce que**
une couche donneuse électriquement conductrice (26), en particulier constituée d'un métal et/ou d'un alliage métallique et/ou d'un semi-conducteur, est utilisée et/ou **en ce qu'**un donneur (18) est utilisé, lequel donneur comprend au moins deux couches donneuses (26).

5. Procédé selon l'une des revendications 1 à 4,
**caractérisé en ce que**
un donneur (18) est utilisé, lequel donneur comporte, sur la couche donneuse (26), au moins un revêtement supplémentaire (30) constitué d'un oxyde.

6. Procédé selon l'une des revendications 1 à 5,
**caractérisé en ce que**
au moins la couche donneuse (26) est tempérée à une température prédéfinie, en particulier à une température comprise entre 30 °C et 250 °C.

7. Procédé selon l'une des revendications 1 à 6,
**caractérisé en ce que**
le donneur (18) est disposé à une distance (A) du substrat (12) comprise entre 0 mm et 20 mm.

8. Procédé selon l'une des revendications 1 à 7,
**caractérisé en ce que**
la teneur en oxygène de l'atmosphère ambiante est réglée à une valeur prédéfinie dans la zone où le transfert se produit et/ou **en ce qu'**au moins une zone, dans laquelle une partie de la couche donneuse (26) est séparée du donneur (18) et transférée sur le substrat, est soumise à un gaz protecteur et/ou est au moins partiellement sous vide.

9. Procédé selon l'une des revendications 1 à 8,
**caractérisé en ce que**
un faisceau laser et/ou un faisceau d'électrons est utilisé en tant que faisceau d'énergie (32) et/ou **en ce que** le faisceau d'énergie (32) est pulsé, en particulier avec une durée d'impulsion comprise entre 1 fs et 1 ms, et/ou **en ce qu'**une puissance du faisceau d'énergie (32) est réglée de telle sorte que la partie à séparer de la couche donneuse (26) s'évapore et/ou fond au moins partiellement.

10. Procédé selon l'une des revendications 1 à 9,
**caractérisé en ce que**
un substrat en forme de bande (12) et/ou un donneur en forme de bande (18) est utilisé.

11. Procédé selon l'une des revendications 1 à 10,
**caractérisé en ce que**
le substrat (12) est imprimé au moins dans certaines zones, après le transfert du donneur (18).

12. Découpe pour un emballage, incluant un substrat (12) fabriqué selon un procédé de l'une des revendications 1 à 11.

13. Emballage, en particulier pour des articles de tabac et/ou des liquides, fabriqué à partir d'une découpe selon la revendication 12.
